# EUROPÄISCHE PATENTSCHRIFT

(11) **EP 4 000 149 B1**
(45) Veröffentlichungstag und Bekanntmachung des Hinweises auf die Patenterteilung: **21.05.2025**
(21) Anmeldenummer: 20746896.8
(22) Anmeldetag: 15.07.2020
(51) Int. Cl.: H02G 15/068, H02G 15/184

(54) **ELEKTRISCHE LEITERANORDNUNG**
ELECTRICAL CONDUCTOR ARRANGEMENT
DISPOSITIF CONDUCTEUR ÉLECTRIQUE

(30) Priorität: 27.09.2019 EP 19200091
(43) Veröffentlichungstag der Anmeldung: 25.05.2022
(73) Patentinhaber: Innomotics GmbH, 90441 Nürnberg (DE)
(72) Erfinder: FESTA, Marco, 14612 Falkensee (DE); GREINACHER, Moritz, 14197 Berlin (DE)
(74) Vertreter: Michalski Hüttermann & Partner Patentanwälte mbB
(86) Internationale Anmeldenummer: PCT/EP2020/069943
(87) Internationale Veröffentlichungsnummer: WO 2021/058160

(56) Entgegenhaltungen:
- EP-A1- 0 445 490
- DE-U- 1 777 892
- DE-U1- 7 722 352
- JP-A- H10 243 540

## Beschreibung

Die Erfindung betrifft eine elektrische Leiteranordnung mit einem elektrischen Leiter, einem wenigstens um einen Leiterabschnitt des Leiters herum angeordneten elektrisch isolierenden Isoliermantel und einer elektrisch leitfähigen Hülle, die um einen Isoliermantelabschnitt des Isoliermantels herum angeordnet ist.

Derartige Leiteranordnungen werden in und/oder an vielen elektrischen Betriebsmitteln, beispielsweise in elektrischen Durchführungen durch Gehäuseöffnungen, oder an Kabeln eingesetzt, wobei die elektrisch leitfähige Hülle einer Leiteranordnung beispielsweise zum Abschirmen elektrischer Felder dient. Eine besondere Schwachstelle einer derartigen Leiteranordnung ist der Bereich, in dem die Hülle um den Isoliermantel endet. In diesem Bereich kann es aufgrund hoher Feldstärken eines elektrischen Feldes am Ende der als elektrische Elektrode wirkenden Hülle zu erheblichen Entladungen ("Funken") auf der Oberfläche des Isoliermantels kommen, die den Isoliermantel in kurzer Zeit beschädigen oder zerstören können. Dieser Effekt wird weiter verstärkt, wenn das Ende der Hülle scharfkantig ausgeführt ist, weil kleine Radien einer Kante der Hülle in der Umgebung der Kante zu besonders hohen elektrischen Feldstärken führen.

Maßnahmen, die die lokalen elektrischen Feldstärken beeinflussen, werden als Feldsteuerung bezeichnet. Elemente zur Feldsteuerung werden als Feldsteuerelemente bezeichnet. Je nach Anforderung an die Feldsteuerung werden verschiedene Maßnahmen eingesetzt. So kann es zum Beispiel ausreichen, die Radien einer Elektrode groß genug auszuführen, um die Feldstärke an der Grenzfläche unterhalb der elektrischen Festigkeit des Isoliermantels zu halten. Diese Art der Feldsteuerung wird als geometrische Feldsteuerung bezeichnet.

Alternativ können als Feldsteuerelemente schwach leitfähige Beläge in Form von Lacken, Bändern, oder gefüllten Kunststoffen auf die Oberfläche des Isoliermantels aufgebracht werden. Das elektrische Feld treibt einen Strom durch diese Stoffe, der zusammen mit ihrem Widerstand zu einem Spannungsabfall führt. Dieser Spannungsabfall wiederum definiert das Potenzial entlang der Oberfläche. Je präziser der Widerstand eingestellt werden kann, desto präziser kann das Potenzial und damit das Feld gesteuert werden. Diese Art der Feldsteuerung wird als resistive Feldsteuerung bezeichnet. Entlang eines solchen Systems ist die Feldstärke bei Wechselspannung jedoch nicht konstant, da ein Teil des Stroms kapazitiv über den Isoliermantel zum Leiter der Leiteranordnung fließt. Dadurch fällt der Spannungsabfall weiter von der Hülle entfernt geringer aus. Dem kann entgegengewirkt werden, indem der Widerstand über die Länge des Feldsteuerelements gesenkt wird.

Eine weitere Möglichkeit besteht darin, Materialien zu verwenden, deren Leitfähigkeit eine starke Abhängigkeit von der anliegenden Feldstärke zeigt. An besonders feldstärkebelasteten Stellen werden solche Stoffe leitfähiger, wodurch die Feldstärke weiter reduziert wird. Diese Art der Feldsteuerung wird als nichtlineare Feldsteuerung bezeichnet.

Alternativ können für Wechselspannungssysteme so genannte refraktive Materialien verwendet werden, die eine hohe relative Permittivität haben. Diese Stoffe "brechen" das elektrische Feld an ihrer Grenzfläche zur Isolierung und drängen es somit weg von der Elektrodenkante. Diese Art der Feldsteuerung wird als refraktive Feldsteuerung bezeichnet.

Aus der DE 77 22 352 U1 ist ein Endverschluss eines kunststoffisolierten Starkstromkabels bekannt. Daraus ist ein Feldsteuerungstrichter bekannt, in dessen Mantel ein durchgehender Leitungsdraht eingebettet ist.

Aus der DE 17 77 892 U ist eine Vorrichtung zur Herstellung von Endverschlüssen für Hochspannungskabel, Hochspannungsdurchführen für Transformatoren, Wandlern oder dergleichen aus gießbaren, härtbaren oder selbsthärtenden Isoliermassen mit leitenden Einlagen zur Potentialsteuerung, bekannt. In die Gießform können vor dem Eingießen der Masse konzentrische Ringe aus leitenden Stoffen, insbesondere Metall, eingelegt werden. Die Ringe können durch Stege oder Fäden aus einem Isolierstoff mit der Gießmasse entsprechenden chemischen und physikalischen Eigenschaften in der Form festgelegt werden.

Der Erfindung liegt die Aufgabe zugrunde, eine elektrische Leiteranordnung der oben beschriebenen Art mit einer einfach, präzise und den jeweiligen Anforderungen anpassbar realisierbaren Feldsteuerung, insbesondere für elektrische Durchführungen und Kabel, anzugeben.

Die Aufgabe wird erfindungsgemäß durch eine elektrische Leiteranordnung mit den Merkmalen des Anspruchs 1, ein Verfahren zum Herstellen einer elektrischen Leiteranordnung mit den Merkmalen des Anspruchs 10, eine elektrische Durchführung mit den Merkmalen des Anspruchs 11 und ein Kabel mit den Merkmalen des Anspruchs 12 gelöst.

Vorteilhafte Ausgestaltungen der Erfindung sind Gegenstand der Unteransprüche.

Eine erfindungsgemäße elektrische Leiteranordnung umfasst einen elektrische Leiter, einen wenigstens um einen Leiterabschnitt des Leiters herum angeordneten elektrisch isolierenden Isoliermantel, eine elektrisch leitfähige Hülle, die um einen ersten Isoliermantelabschnitt des Isoliermantels herum angeordnet ist, und ein elektrisch leitfähiges Garn, das zur elektrischen Feldsteuerung um einen an den ersten Isoliermantelabschnitt angrenzenden zweiten Isoliermantelabschnitt des Isoliermantels gewickelt ist. Zum Wickeln wird insbesondere ein Wickelgerät verwendet. Zum Wickeln wird eine Rotationsbewegung ausgeführt. Rotiert wird beispielsweise die Leiteranordnung mit dem Isoliermantel. Es ist beispielsweise auch möglich beim Wickeln die Leiteranordnung mit dem Isoliermantel zu fixieren und das Garn mittels einer sich rotierenden Vorrichtung um die Leiteranordnung auf den Isoliermantel zu wickeln. Das Garn (das elektrisch leitfähige Garn) ist direkt auf den Isoliermantel wickelbar. Das Garn (das elektrisch leitfähige Garn) ist bzw. wird also direkt auf den Isoliermantel gewickelt.

Eine erfindungsgemäße elektrische Leiteranordnung weist also ein elektrisch leitfähiges Garn zur Feldsteuerung auf. Das Garn ist um einen Isoliermantelabschnitt eines Isoliermantels gewickelt, der einen daran angrenzenden Isoliermantelabschnitt zwischen einem Leiter und einer elektrisch leitfähigen Hülle der Leiteranordnung aufweist. Das Garn wird dabei als ein Feldsteuerelement für ein elektrisches Feld am Ende der elektrisch leitfähigen Hülle eingesetzt. Durch die Wahl des Materials, aus dem das Garn gefertigt ist, und die Ausführung der Wicklung des Garns kann vorteilhaft eine präzise und variabel den jeweiligen Anforderungen anpassbare Feldsteuerung realisiert werden, die einen nur geringen Bauraum erfordert und daher insbesondere bei begrenztem Platzbedarf vorteilhaft verwendbar ist.

Bei einer Ausgestaltung der Erfindung ist ein Garnendabschnitt des Garns mit einem Hüllenendabschnitt der Hülle, beispielsweise durch Kleben, verbunden. Dadurch wird vorteilhaft ein Garnendabschnitt des Garns in der Nähe des Hüllenendabschnitts der Hülle fixiert und das Garn wird galvanisch und/oder kapazitiv elektrisch an die Hülle gekoppelt.

Bei einer weiteren Ausgestaltung der Erfindung ist das Garn helixartig um den zweiten Isoliermantelabschnitt gewickelt. Insbesondere kann die helixartige Wicklung des Garns unterschiedliche Steigungen aufweisen. Dadurch kann durch die Steigung der helixartigen Wicklung und deren Variation entlang des Verlaufs der Wicklung der elektrische Widerstand der Wicklung und seine lokale Variation in einer zum Leiter parallelen Richtung flexibel den jeweiligen Anforderungen an die Feldsteuerung angepasst werden.

Bei einer weiteren Ausgestaltung der Erfindung weist das Garn eine geringere spezifische elektrische Leitfähigkeit als die Hülle auf. Bei einer weiteren Ausgestaltung der Erfindung weist das gewickelte Garn einen elektrischen Widerstand im Bereich zwischen 1 MΩ/m und 100 MΩ/m auf. Diese Ausgestaltungen der Erfindung sind typischen Ausführungen elektrisch leitfähiger Hüllen angepasst.

Bei weiteren Ausgestaltungen der Erfindung ist das Garn aus einer Polyamidfaser, die von einem elektrisch leitfähigen kohlenstoffhaltigen Material umhüllt ist, oder aus einem Fasergemisch, das wenigstens eine Polyamidfaser und eine elektrisch leitfähige Kohlenstofffaser umfasst, oder aus einer metallischen Faser gefertigt. Die genannten Materialien ermöglichen die Herstellung von elektrisch schwach leitfähigem gewickeltem Garn und eignen sich daher in besonderem Maße zur Fertigung von Garn für eine erfindungsgemäße Leiteranordnung.

Bei einer weiteren Ausgestaltung der Erfindung ist das Garn von einer Schutzschicht oder Schutzhülle umgeben. Dadurch kann das Garn vorteilhaft gegen mechanische und/oder chemische Beeinträchtigungen geschützt werden. Ferner kann durch eine geeignete Wahl des Materials und/oder eine geeignete Gestaltung der Schutzschicht oder Schutzhülle die elektrische Durchschlagsfestigkeit des aus dem Garn und der Schutzschicht oder Schutzhülle bestehenden Systems erhöht werden.

Bei einer Ausgestaltung der Erfindung ist das Garn durch ein aushärtendes oder aushärtbares Harz an dem zweiten Isoliermantelabschnitt fixiert. Dadurch kann das Garn vorteilhaft stabilisiert und gegen lokale und globale mechanische Verschiebungen geschützt werden. Insbesondere können im Falle einer helixartigen Wicklung des Garns die lokalen Steigungen der Wicklung fixiert werden.

Bei dem erfindungsgemäßen Verfahren zum Herstellen einer erfindungsgemäßen Leiteranordnung wird dementsprechend zum Fixieren des Garns an dem zweiten Isoliermantelabschnitt ein aushärtendes oder aushärtbares Harz auf den zweiten Isoliermantelabschnitt aufgebracht und das Garn wird vor dem vollständigen Aushärten des Harzes auf dem Harz um den zweiten Isoliermantelabschnitt gewickelt.

Eine erfindungsgemäße elektrische Durchführung durch eine Gehäuseöffnung eines Gehäuses eines elektrischen Betriebsmittels weist eine erfindungsgemäße Leiteranordnung auf, deren Hülle elektrisch mit dem Gehäuse verbunden und mit dem Leiter und dem Isoliermantel durch die Gehäuseöffnung geführt ist.

Ein erfindungsgemäßes Kabel weist eine erfindungsgemäße Leiteranordnung auf.

Da eine erfindungsgemäße elektrische Durchführung und ein erfindungsgemäßes Kabel eine erfindungsgemäße Leiteranordnung aufweisen, ergeben sich deren Vorteile aus den oben genannten Vorteilen einer erfindungsgemäßen Leiteranordnung.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine teilweise geschnittene Darstellung eines Ausführungsbeispiels einer elektrischen Leiteranordnung,
- FIG 2: eine teilweise geschnittene Darstellung eines Ausführungsbeispiels einer elektrischen Durchführung,
- FIG 3: eine teilweise geschnittene Darstellung eines Ausführungsbeispiels eines Kabels.

Einander entsprechende Teile sind in den Figuren mit denselben Bezugszeichen versehen.

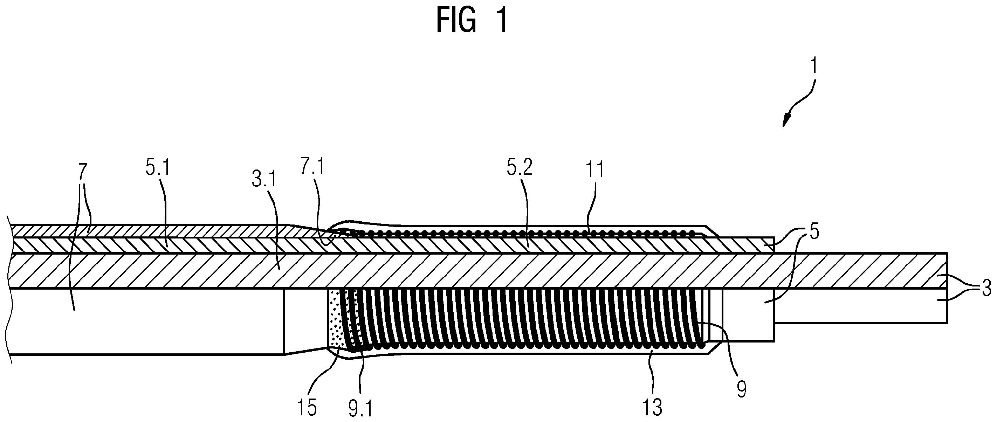

FIG 1 zeigt ein Ausführungsbeispiel einer erfindungsgemäßen elektrischen Leiteranordnung 1 in einer teilweise geschnittenen Darstellung, wobei der obere Teil der FIG 1 die Leiteranordnung 1 geschnitten darstellt ist. Die Leiteranordnung 1 umfasst einen elektrischen Leiter 3, einen elektrisch isolierenden Isoliermantel 5, eine elektrisch leitfähige Hülle 7, ein elektrisch leitfähiges Garn 9 zur elektrischen Feldsteuerung, eine Harzschicht 11 und eine Schutzschicht 13.

Der Isoliermantel 5 ist um einen Leiterabschnitt 3.1 des Leiters 3 herum angeordnet. Die Hülle 7 ist um einen ersten Isoliermantelabschnitt 5.1 des Isoliermantels 5 herum angeordnet. Die Harzschicht 11 ist auf eine Außenoberfläche eines an den ersten Isoliermantelabschnitt 5.1 angrenzenden zweiten Isoliermantelabschnitts 5.2 des Isoliermantels 5 aufgetragen. Das Garn 9 ist an der Harzschicht 11 helixartig um den zweiten Isoliermantelabschnitt 5.2 gewickelt. Die Harzschicht 11 fixiert das Garn 9 an dem zweiten Isoliermantelabschnitt **5.2.** Ein Garnendabschnitt 9.1 des Garns 9 ist mit einem Hüllenendabschnitt 7.1 der Hülle 7 elektrisch leitfähig verbunden und durch einen Kleber 15 stoffschlüssig an dem Hüllenendabschnitt 7.1 fixiert. Der Hüllenendabschnitt 7.1 weist einen zu dem zweiten Isoliermantelabschnitt 5.2 hin konisch abnehmenden Außendurchmesser auf. Die Schutzschicht 13 ist um das Garn 9 und die Harzschicht 11 herum angeordnet. Die Schutzschicht 13 ist transparent dargestellt, kann jedoch auch intransparent ausgeführt sein.

Der Leiter 3 ist beispielsweise aus Kupfer gefertigt. Der Isoliermantel 5 ist beispielsweise aus Polyetheretherketon (PEEK), vernetztem Polyethylen (VPE), Polyvinylchlorid (PVC) oder einen vergleichbarem Polymer, Öl-Papier, Keramik, Silikon, harzgetränkten Glimmerbändern oder Kunstharz gefertigt. Die Hülle 7 ist beispielsweise aus einem Edelstahl gefertigt. Das Garn 9 ist beispielsweise aus einer Polyamidfaser, die von einem elektrisch leitfähigen kohlenstoffhaltigen Material umhüllt ist, aus einem Fasergemisch, das wenigstens eine Polyamidfaser und eine elektrisch leitfähige Kohlenstofffaser umfasst, oder aus einer dünnen metallischen Faser gefertigt. Die Harzschicht 11 ist aus einem aushärtenden oder aushärtbaren Harz, beispielsweise aus Epoxidharz, gefertigt. Die Schutzschicht 13 ist beispielsweise ebenfalls aus einem aushärtenden oder aushärtbaren Harz gefertigt, insbesondere aus demselben Harz wie die Harzschicht 11.

Das Garn 9 weist eine geringere spezifische elektrische Leitfähigkeit als die Hülle 7 auf. Beispielsweise weist das gewickelte Garn 9 einen elektrischen Widerstand im Bereich zwischen 1 MΩ/m und 100 MΩ/m auf.

Bei der Herstellung der Leiteranordnung 1 wird zunächst ein Grundkörper hergestellt, der den Leiter 3, den Isoliermantel 5 und die Hülle 7 umfasst. Anschließend wird Harz für die Harzschicht 11 auf den zweiten Isoliermantelabschnitt 5.2 aufgebracht. Danach wird das Garn 9 um den Hüllenendabschnitt 7.1 und um den zweiten Isoliermantelabschnitt 5.2 gewickelt und dabei an das Harz gedrückt und durch den Kleber 15 mit dem Hüllenendabschnitt 7.1 verbunden. Abschließend wird Material für die Schutzschicht 13 auf das Garn 9 und die Harzschicht 11 aufgebracht.

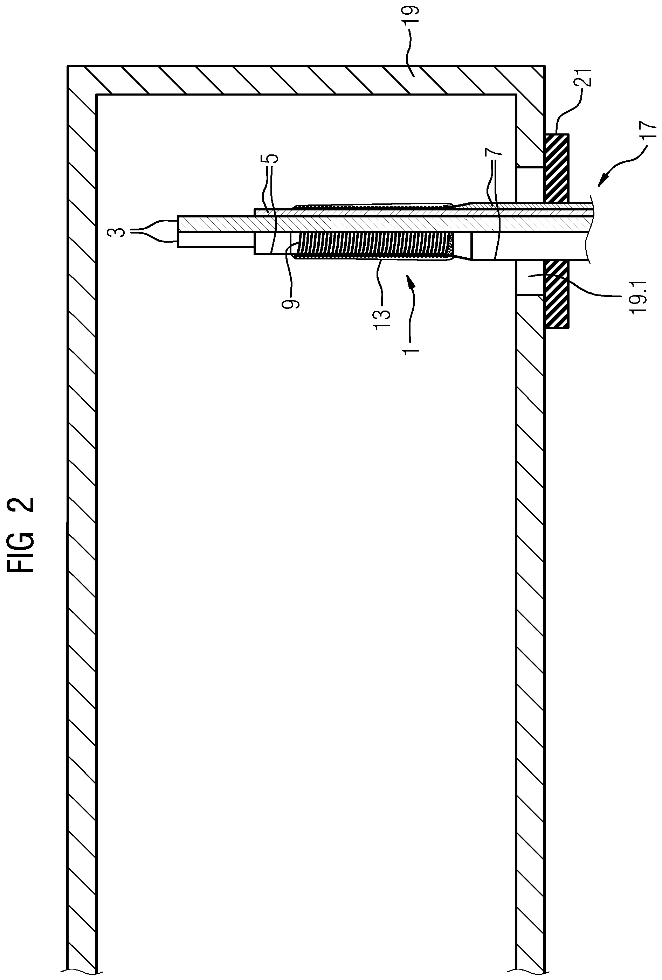

FIG 2 zeigt eine teilweise geschnittene Darstellung eines Ausführungsbeispiels einer erfindungsgemäßen elektrischen Durchführung 17 durch eine Gehäuseöffnung 19.1 eines elektrisch leitfähigen Gehäuses 19 eines elektrischen Betriebsmittels. Das elektrische Betriebsmittel ist beispielsweise eine elektrische Maschine wie ein Motor, ein Generator oder ein Transformator, oder ein elektrisches Schaltgerät wie ein Leistungsschalter oder ein Trennschalter. Die Durchführung 17 umfasst eine wie in FIG 1 ausgebildete Leiteranordnung 1 und eine Dichtung 21. Das Gehäuse 19 und die Dichtung 21 sind geschnitten dargestellt, die Leiteranordnung 1 ist wie in Figur 1 teilweise geschnitten dargestellt. Der Isoliermantelabschnitt 5.2 der Leiteranordnung 1 ist innerhalb des Gehäuses 19 angeordnet. Die Hülle 7 ragt aus der Gehäuseöffnung 19.1 heraus. Die Dichtung 21 verläuft ringförmig um die Hülle 7, verbindet die Hülle 7 elektrisch leitend mit dem Gehäuse 19 und dichtet die Gehäuseöffnung 19.1 ab. Beispielsweise ist die Hülle 7 aus einem Material gefertigt, das Graphit enthält. Der Leiter 3 ist mit einem Strompfad des elektrischen Betriebsmittels verbunden oder verbindbar (im Fall, dass das elektrische Betriebsmittel eine elektrische Maschine ist, ist der Leiter 3 beispielsweise mit einer Wicklung der Maschine verbunden; im Fall, dass das elektrische Betriebsmittel ein elektrisches Schaltgerät ist, ist der Leiter 3 beispielsweise mit einem Schaltkontakt des Schaltgeräts verbunden). Die Hülle 7 und das Gehäuse 19 sind beispielsweise mit Erdpotential verbunden.

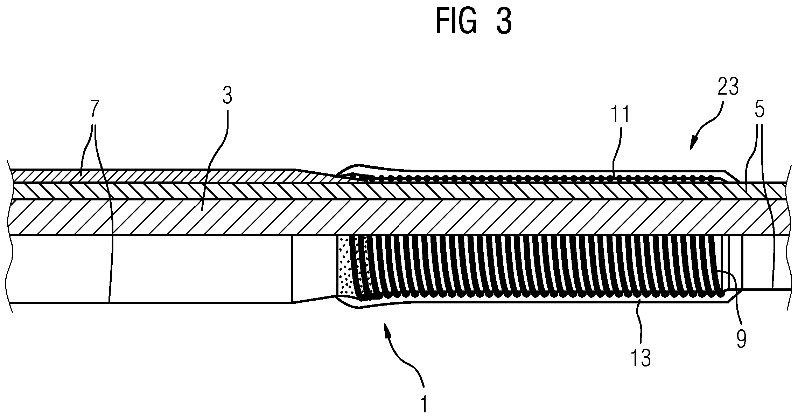

FIG 3 zeigt analog zu FIG 1 eine teilweise geschnittene Darstellung eines Ausführungsbeispiels eines erfindungsgemäßen Kabels 23. Das Kabel 23 umfasst eine wie in FIG 1 ausgebildete Leiteranordnung 1, die ein erstes Kabelende des Kabels 23 bildet, wobei der Isoliermantel 5 um den Leiter 3 herum bis zu einem (nicht dargestellten) zweiten Kabelende des Kabels 23 verläuft. Das zweite Kabelende kann wie das erste Kabelende ausgebildet sein.

Die in den Figuren 1 bis 3 gezeigten Ausführungsbeispiele von Leiteranordnungen 1 können in verschiedener Weise abgewandelt werden. Insbesondere kann die helixartige Wicklung des Garns 9 lokal unterschiedliche Steigungen aufweisen, um den elektrischen Widerstand der Wicklung entlang ihres Verlaufes zu verändern und den Anforderungen an die Feldsteuerung anzupassen. Ferner kann statt einer Schutzschicht 13 eine Schutzhülle vorgesehen sein, die das Garn 9 und die Harzschicht 11 einhüllt. Weitere Ausführungsbeispiele einer erfindungsgemäßen Leiteranordnung 1 weisen gar keine Harzschicht 11 und/ oder keine Schutzschicht 13 auf. Bei weiteren Ausführungsbeispielen ist das Garn 9 nicht mit der Hülle 7 elektrisch verbunden, sondern an die Hülle 7 nur kapazitiv gekoppelt.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Elektrische Leiteranordnung (1), umfassend
- einen elektrischen Leiter (3),
- einen wenigstens um einen Leiterabschnitt (3.1) des Leiters (3) herum angeordneten elektrisch isolierenden Isoliermantel (5),
- eine elektrisch leitfähige Hülle (7), die um einen ersten Isoliermantelabschnitt (5.1) des Isoliermantels (5) herum angeordnet ist,
**dadurch gekennzeichnet, dass** ein elektrisch leitfähiges Garn (9) zur elektrischen Feldsteuerung um einen an den ersten Isoliermantelabschnitt (5.1) angrenzenden zweiten Isoliermantelabschnitt (5.2) des Isoliermantels (5) gewickelt ist, wobei das Garn (9) aus einer Polyamidfaser gefertigt ist, die von einem elektrisch leitfähigen kohlenstoffhaltigen Material umhüllt ist oder wobei das Garn (9) aus einem Fasergemisch gefertigt ist, das wenigstens eine Polyamidfaser und eine elektrisch leitfähige Kohlenstofffaser umfasst.

2. Leiteranordnung (1) nach Anspruch 1, wobei ein Garnendabschnitt (9.1) des Garns (9) mit einem Hüllenendabschnitt (7.1) der Hülle (7), beispielsweise durch Kleben, verbunden ist.

3. Leiteranordnung (1) nach Anspruch 1 oder 2, wobei das Garn (9) helixartig um den zweiten Isoliermantelabschnitt (5.2) gewickelt ist.

4. Leiteranordnung (1) nach Anspruch 2, wobei die helixartige Wicklung des Garns (9) unterschiedliche Steigungen aufweist.

5. Leiteranordnung (1) nach einem der vorhergehenden Ansprüche, wobei das Garn (9) eine geringere spezifische elektrische Leitfähigkeit als die Hülle (7) aufweist.

6. Leiteranordnung (1) nach einem der vorhergehenden Ansprüche, wobei das gewickelte Garn (9) einen elektrischen Widerstand im Bereich zwischen 1 MΩ/m und 100 MΩ/m aufweist.

7. Leiteranordnung (1) nach einem der Ansprüche 1 bis 6, wobei das Garn (9) aus wenigstens einer metallischen Faser gefertigt ist.

8. Leiteranordnung (1) nach einem der vorhergehenden Ansprüche, wobei das Garn (9) von einer Schutzschicht (13) oder Schutzhülle umgeben ist.

9. Leiteranordnung (1) nach einem der vorhergehenden Ansprüche, wobei das Garn (9) durch ein aushärtendes oder aushärtbares Harz an dem zweiten Isoliermantelabschnitt (5.2) fixiert ist.

10. Verfahren zum Herstellen einer Leiteranordnung (1) nach einem der vorhergehenden Ansprüche, wobei
- zum Fixieren des Garns (9) an dem zweiten Isoliermantelabschnitt (5.2) ein aushärtendes oder aushärtbares Harz auf den zweiten Isoliermantelabschnitt (5.2) aufgebracht wird und
- das Garn (9) vor dem vollständigen Aushärten des Harzes auf dem Harz um den zweiten Isoliermantelabschnitt (5.2) gewickelt wird.

11. Elektrische Durchführung (17) durch eine Gehäuseöffnung (19.1) eines Gehäuses (19) eines elektrischen Betriebsmittels, wobei die Durchführung (17) eine Leiteranordnung (1) nach einem der Ansprüche 1 bis 9 aufweist, deren Hülle (7) elektrisch mit dem Gehäuse (19) verbunden und zusammen mit dem Leiter (3) und dem ersten Isoliermantelabschnitt (5.1) des Isoliermantels (5) durch die Gehäuseöffnung (19.1) geführt ist.

12. Kabel (23) mit einer Leiteranordnung (1) nach einem der Ansprüche 1 bis 9.

## Claims

1. Electrical conductor assembly (1) comprising
- an electrical conductor (3)
- an electrically insulating jacket (5) disposed around at least one conductor section (3.1) of the conductor (3),
- an electrically conductive sleeve (7) disposed around a first insulating jacket section (5.1) of the insulating jacket (5),
**characterised in that**, for electric field control, an electrically conductive yarn (9) is wound around a second insulating jacket section (5.2) of the insulating jacket (5) adjacent to the first insulating jacket section (5.1), wherein the yarn (9) is made of a polyamide fibre sheathed with an electrically conductive carbon-containing material or wherein the yarn (9) is made of a fibre blend comprising at least a polyamide fibre and an electrically conductive carbon fibre.

2. Conductor assembly (1) according to claim 1, wherein a yarn end section (9.1) of the yarn (9) is bonded, e.g. adhesively, to a sleeve end section (7.1) of the sleeve (7).

3. Conductor assembly (1) according to claim 1 or 2, wherein the yarn (9) is helically wound around the second insulating jacket section (5.2).

4. Conductor assembly (1) according to claim 2, wherein the helical winding of the yarn (9) has different pitches.

5. Conductor assembly (1) according to one of the preceding claims, wherein the yarn (9) has a lower specific electrical conductivity than the sleeve (7).

6. Conductor assembly (1) according to one of the preceding claims, wherein the wound yarn (9) has an electrical resistance in the range between 1 MΩ/m and 100 MΩ/m.

7. Conductor assembly (1) according to one of claims 1 to 6, wherein the yarn (9) is made of at least one metallic fibre.

8. Conductor assembly (1) according to one of the preceding claims, wherein the yarn (9) is surrounded by a protective layer (13) or protective wrapper.

9. Conductor assembly (1) according to one of the preceding claims, wherein the yarn (9) is fixed to the second insulating jacket section (5.2) by a curing or curable resin.

10. Method for manufacturing a conductor assembly (1) according to one of the preceding claims, wherein
- a curing or curable resin is applied to the second insulating jacket section (5.2) to fix the yarn (9) to the second insulating jacket section (5.2), and
- the yarn (9) is wound around the second insulating jacket section (5.2) on the resin before the resin is completely cured.

11. Electrical bushing (17) through an enclosure opening (19.1) of an enclosure (19) of an item of electrical equipment, wherein the bushing (17) comprises a conductor assembly (1) according to one of claims 1 to 9, the sleeve (7) of which is electrically connected to the enclosure (19) and is fed through the enclosure opening (19.1) together with the conductor (3) and the first insulating jacket section (5.1) of the insulating jacket (5).

12. Cable (23) having a conductor assembly (1) according to one of claims 1 to 9.

## Revendications

1. Dispositif (1) conducteur électrique, comprenant
- un conducteur (3) électrique,
- au moins une chemise (5) isolante électriquement disposée autour d'un tronçon (3.1) du conducteur (3),
- une gaine (7) conductrice de l'électricité, qui est disposée autour d'un premier tronçon (5.1) de la chemise (5) isolante,
**caractérisé en ce qu'**un fil (9) conducteur de l'électricité est, pour la commande du champ électrique, enroulé autour d'un deuxième tronçon (5.2), contigu au premier tronçon (5.1) de la chemise (5) isolante, dans lequel le fil (9) est en une fibre de polyamide, qui est gainée d'un matériau contenant du carbone conducteur de l'électricité ou dans lequel le fil (9) est en un mélange de fibres, qui comprend au moins une fibre de polyamide et une fibre de carbone conductrice de l'électricité.

2. Agencement (1) conducteur suivant la revendication 1, dans lequel un tronçon (9.1) du fil (9) est relié, par exemple par collage, à un tronçon (7.1) d'extrémité de la gaine (7).

3. Agencement (1) conducteur suivant la revendication 1 ou 2, dans lequel le fil (9) est enroulé en hélice autour du deuxième tronçon (5.2) de la chemise isolante.

4. Agencement (1) conducteur suivant la revendication 2, dans lequel l'enroulement de type en hélice du fil (9) a des pas différents.

5. Agencement (1) conducteur suivant l'une des revendications précédentes, dans lequel le fil (9) a une conductivité électrique spécifique plus petite que la gaine (7).

6. Agencement (1) conducteur suivant l'une des revendications précédentes, dans lequel le fil (9) enroulé a une résistance électrique dans la plage comprise entre 1 MΩ/m et 100 MΩ/m.

7. Agencement (1) conducteur suivant l'une des revendications 1 à 6, dans lequel le fil (9) est fabriqué en au moins une fibre métallique.

8. Agencement (1) conducteur suivant l'une des revendications précédentes, dans lequel le fil (9) est entouré d'une couche (13) de protection ou d'une gaine de protection.

9. Agencement (1) conducteur suivant l'une des revendications précédentes, dans lequel le fil (9) est fixé sur le deuxième tronçon (5.2) de la chemise isolante par une résine à durcir ou durcissable.

10. Procédé de fabrication d'un agencement (1) conducteur suivant l'une des revendications précédentes, dans lequel
- pour fixer le fil (9) sur le deuxième tronçon (5.2) de la chemise isolante, on dépose une résine à durcir ou durcissable sur le deuxième tronçon (5.2) de la chemise isolante et
- on enroule le fil (9) sur la résine autour du deuxième tronçon (5.2) de la chemise isolante avant le durcissement complet de la résine.

11. Traversée (17) électrique dans une ouverture (19.1) d'une enveloppe (19) d'un moyen de fonctionnement électrique, dans laquelle la traversée (17) a un agencement (1) conducteur suivant l'une des revendications 1 à 9, dont la gaine (7) est connectée électriquement à l'enveloppe (19) et ensemble avec le conducteur (3) et le premier tronçon (5.1) de la chemise (5) isolante passe dans l'ouverture (19.1) de l'enveloppe.

12. Câble (23) ayant un agencement (1) de conducteur suivant l'une des revendications 1 à 9.
